# EUROPEAN PATENT SPECIFICATION

(11) **EP 4 107 778 B1**
(45) Date of publication and mention of the grant of the patent: **01.04.2026**
(21) Application number: 20920138.3
(22) Date of filing: 17.02.2020
(51) Int. Cl.: H01L 21/687, H01L 21/677, B25J 15/00, B25J 15/02, B25J 11/00

(54) **APPARATUS, SYSTEM AND METHOD FOR PROVIDING SELF EXTRACTING GRIPS FOR AN END EFFECTOR**
VORRICHTUNG, SYSTEM UND VERFAHREN ZUR BEREITSTELLUNG VON SELBSTAUSZIEHGRIFFEN FÜR EINEN ENDEFFEKTOR
APPAREIL, SYSTÈME ET PROCÉDÉ POUR FOURNITURE DE PINCES À AUTO-EXTRACTION POUR EFFECTEUR TERMINAL

(43) Date of publication of application: 28.12.2022
(73) Proprietor: Jabil Inc., St. Petersburg, Florida 33716 (US)
(72) Inventor: BOSBOOM, Jeroen, St. Petersburg, Florida 33716 (US)
(74) Representative: Gulde & Partner
(86) International application number: PCT/US2020/018507
(87) International publication number: WO 2021/167584

(56) References cited:
- JP-A- 2011 119 348
- JP-A- H11 163 113
- KR-B1- 100 798 483
- US-A- 6 116 848
- US-A1- 2011 211 936
- US-A1- 2011 211 936
- US-A1- 2018 161 989

## Description

### BACKGROUND

### Field of the Disclosure

The present disclosure relates to the transfer and processing of articles, such as semiconductor wafers, and more particularly to an apparatus, system and method for providing self extracting grips for an end effector.

### Description of the Background

The use of robotics is well established as a manufacturing expedient, particularly in applications where human handling is inefficient and/or undesirable. One such circumstance is in the semiconductor arts, in which robotics and automated stations are used to handle and hold wafers during various process steps. Such process steps may include, by way of example, chemical mechanical planarization (CMP), etching, deposition, passivation, and various other processes in which a sealed and/or "clean" environment must be maintained, such as to limit the likelihood of contamination and to ensure that various specific processing conditions are met.

Current practice in the semiconductor arts to robotically handle these wafers often includes the use of an end effector operably attached to the robotics, such as in order to load semiconductor wafers from a loading stack into the various processing ports that may correspond to the aforementioned exemplary process steps. The robotics are employed to deploy the end effector to retrieve the wafer from a particular port or stack, such as before and/or after processing in an associated process chamber, and/or to associate the wafer with a station, such as may include a station chuck onto which the wafer is placed.

The wafer may thus be shuttled by the robotics connectively associated with the end effector between stations for additional processing. When a given wafer process is complete, the robotics may move the processed wafer from its station and return the processed semiconductor wafer to a loading port. It is typical that a stack of several semiconductor wafers is processed in this manner during each process run.

The known art also includes robotics to flip and rotate wafers and similar substrates, such as for inspection during or after processing. However, the typical type of end effector in substantial use in the known art is an edge grip wafer handler. In an edge grip wafer handler, the wafer is only minimally handled, with peripheral contact between the end effector and the wafer only at the wafer's outer circumference. Typically, such edge gripping is provided by mechanical wedges associated at the distal and proximal portions of the end effector (with respect to the corresponding robotic base of the end effector at which robotic movement of the end effector arms and power are provided).

However, these wedge guides may exert unwanted friction on the retained wafer, or insufficient friction if a wafer is flipped or rotated sideways, and consequently may provide unpredictable release and/or release positioning of the wafer due to excessive or insufficient wedge-induced friction. Moreover, as wedge clamps typically cover a portion of the outer circumference of the wafer, these edge clamps, or the wafer tooling passing proximate to these edge clamps, may cause snags on the wafer and consequently damage the wafer. For example, if a wafer experiences friction and travels with a wedge clamp beyond the release point rather than timely extracting from the clamp, the wafer and/or structures thereon will be damaged.

The foregoing wedge clamp friction often occurs due to the passive self-releasing nature of the wedge clamp. That is, typical edge grip designs compromise the wedge angle to approximately 75°, so that the wedge clamp will not exert undue friction and will be self-releasing. However, this angle for the wedge clamp limits the ability to invert or rotate a wafer associated with the wedge clamp, in part because the angle of the wedge clamp is insufficient to retain an inverted or rotated wafer. This problem is exacerbated for thin, flexible, large wafers, which may require more overlap at the wafer's circumference to retain the wafer, and a steeper wedge clamp angle in order to positively capture the wafer, due to the wafer's ability to flex within the clamp, which circumstances may cause self-release of the wafer at an undesired time.

In a particular example, some semiconductor processing applications may require the use of a rotating wrist end effector. A rotating wrist end effector may require a steeper angle and deeper wedge base for the wedge clamp, such that the rotation of the end effector will not improperly self-release a wafer from the wedge clamp. However, in such an instance, the deeper wedge base and steeper wedge clamp angle are substantially more likely to cause undue friction at the desired timing of release, and thereby negate the self-release of the wafer, causing the lack of the desired release and/or damage to the wafer, by way of non-limiting example.

For instance, JP H11 163113 A is directed to a chunk mechanism for various type of substrates, which includes a pair of front arms and a pair of rear arms. US 2011/211936 Al discloses a conveying device which may include a clamp latch mechanism.

### SUMMARY

Certain embodiments are and include an apparatus, system and method for a wedge clamp suitable to provide self extracting grips for an end effector suitable to hold semiconductor wafers.

According to an aspect of the present invention, a wedge clamp according to claim 1 is provided.

According to a further aspect of the invention, an end effector apparatus according to claim 5 is provided. The apparatus includes two inner jaws at least mechanically associated with a robotic base; two outer arms associated with the inner jaws via at least one arms cam system, such as may comprise a servo motor and a timing belt providing the camming; and a plurality of wedge clamps, wherein two of the plurality of wedge clamps are respectively fastened to each of the two inner jaws proximally to the end effector front end, such as its robotic base, and wherein two of the plurality of wedge clamps are respectively fastened to each of the outer arms distally from the end effector front end.

Each of at least one of the distal and the proximal wedge clamps comprises: a spring; a cam loaded on the spring; and a cam travel path into which the cam is contained and guided, such as slidably. Thereby, a contraction of the inner jaws and a consequent arms camming of the outer arms applies pressure to a circumferential edge of the semiconductor wafer such that the circumferential edge depresses each of the cams along its respective cam travel path and against its respective one of the springs, thus loading the cams to grip the semiconductor wafer within the plurality of edge clamps.

Thus, the disclosure provides at least an apparatus, system and method for providing a wedge clamp suitable to provide self extracting grips for an end effector suitable to hold semiconductor wafers.

### BRIEF DESCRIPTION OF THE DRAWINGS

The exemplary compositions, systems, and methods shall be described hereinafter with reference to the attached drawings, which are given as non-limiting examples only, in which:
Figure 1 is an illustration of an end effector for handling semiconductor wafers;
Figure 2 is an illustration of a wafer handling system;
Figures 3 illustrate an end effector and wafer handler;
Figure 4 is an illustration of an end effector with wedge clamps;
Figure 5 is an illustration of an end effector with wedge clamps;
Figure 6 is an illustration of an end effector with wedge clamps; and
Figures 7 and 8 are illustrations of end effectors with wedge clamps.

### DETAILED DESCRIPTION

The figures and descriptions provided herein may have been simplified to illustrate aspects that are relevant for a clear understanding of the herein described apparatuses, systems, and methods, while eliminating, for the purpose of clarity, other aspects that may be found in typical similar devices, systems, and methods. Those of ordinary skill may thus recognize that other elements and/or operations may be desirable and/or necessary to implement the devices, systems, and methods described herein. But because such elements and operations are known in the art, and because they do not facilitate a better understanding of the present disclosure, for the sake of brevity a discussion of such elements and operations may not be provided herein. However, the present disclosure is deemed to nevertheless include all such elements, variations, and modifications to the described aspects that would be known to those of ordinary skill in the art.

Embodiments are provided throughout so that this disclosure is sufficiently thorough and fully conveys the scope of the disclosed embodiments to those who are skilled in the art. Numerous specific details are set forth, such as examples of specific components, devices, and methods, to provide a thorough understanding of embodiments of the present disclosure. Nevertheless, it will be apparent to those skilled in the art that certain specific disclosed details need not be employed, and that embodiments may be embodied in different forms. As such, the disclosed embodiments should not be construed to limit the scope of the disclosure. As referenced above, in some embodiments, well-known processes, well-known device structures, and well-known technologies may not be described in detail.

The terminology used herein is for the purpose of describing particular embodiments only and is not intended to be limiting. For example, as used herein, the singular forms "a", "an" and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The steps, processes, and operations described herein are not to be construed as necessarily requiring their respective performance in the particular order discussed or illustrated, unless specifically identified as a preferred or required order of performance. It is also to be understood that additional or alternative steps may be employed, in place of or in conjunction with the disclosed aspects.

When an element or layer is referred to as being "on", "upon", "connected to" or "coupled to" another element or layer, it may be directly on, upon, connected or coupled to the other element or layer, or intervening elements or layers may be present, unless clearly indicated otherwise. In contrast, when an element or layer is referred to as being "directly on," "directly upon", "directly connected to" or "directly coupled to" another element or layer, there may be no intervening elements or layers present. Other words used to describe the relationship between elements should be interpreted in a like fashion (e.g., "between" versus "directly between," "adjacent" versus "directly adjacent," etc.). Further, as used herein the term "and/or" includes any and all combinations of one or more of the associated listed items.

Yet further, although the terms first, second, third, etc. may be used herein to describe various elements, components, regions, layers and/or sections, these elements, components, regions, layers and/or sections should not be limited by these terms. These terms may be only used to distinguish one element, component, region, layer or section from another element, component, region, layer or section. Thus, terms such as "first," "second," and other numerical terms when used herein do not imply a sequence or order unless clearly indicated by the context. Thus, a first element, component, region, layer or section discussed below could be termed a second element, component, region, layer or section without departing from the teachings of the embodiments.

The embodiments provide a self-extracting wedge clamp for association with an end effector, which may be used in semiconductor processes. The disclosed wedge clamp ensures that released components are released when desired, and stay substantially or completely in the desired position when picked up by the end effector, or when released therefrom, such as staying centered on the wedge clamp. Thereby, the semiconductor wafer or processed part is at the position intended for processing, rather than being randomly positioned such that processes carried out thereon are flawed, or such that intended placement within processes or stacks is missed.

More particularly, one or more of the disclosed edge clamps may be associated with the two, three, or four "corners" of an end effector's grip upon a wafer. The wedge clamps disclosed may include a spring-loaded sliding cam, or "puck", that positively extracts a wafer from the wedge clamp's grip, such as when the pressure exerted by an opposing "corner" wedge clamp is released. That is, the disclosed wedge clamp extraction cam may be passive, at least in that a wafer may be placed upon the arm or arms of end effector, whereafter the end effector may be robotically contracted such that opposing wedge clamps are exerted upon the circumference of a wafer or part.

This exertion of the wedge clamps upon the circumference when the end effector arms are contracted effects a "loading" of the extraction cam into the body of the respective wedge clamp. Thereafter, an increase in the distance between the opposing wedge clamps at opposing "corners" of the end effector, based on robotic expansion of the end effector arms, releases the loading pressure on the spring, thereby allowing the respective extraction cam to be sprung from the wedge clamp housing. This effectuates a release of the wafer or part associated with the end effector. Of course, the skilled artisan will appreciate, in light of the discussion herein, that the extraction cam may not only be passive as disclosed, but may also be active, such as being pneumatically or electrically driven.

Thereby, the disclosed extraction cam may allow for spring loading of a wafer or part into an end effector, thus improving inverted handling and thus providing enhanced positioning and targeted release of the wafer or part associated with the end effector. Moreover, the improved positioning provided by the disclosed wedge clamps having embedded extraction cams may drastically improve self-guiding of the wafer upon release from the wedge clamps, such as wherein a wafer may positively guide itself to reach a pallet mask pocket or a wafer chuck, by way of nonlimiting example.

Of note, although the discussion herein is provided with respect to a cammed, contractable/expandable end effector suitable to handle multiple sizes of semiconductor wafers, the skilled artisan will appreciate that other end effector technologies may be employed to, for example, provide the spring pressure to load a wafer into the wedge clamps, and/or to release the spring pressure to allow self-releasing of the wafer. Moreover, it will be noted that the disclosed wedge clamps and extraction cams may be used with single wafer-size end effectors, or with the aforementioned end effectors capable of handling multiple wafer sizes.

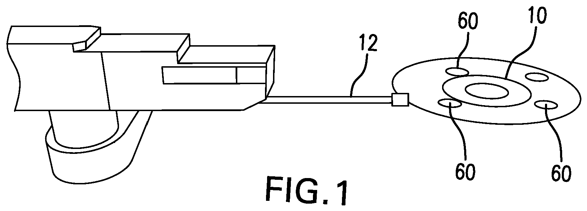

Figure 1 illustrates a wafer 10 associated with an end effector 12. The illustrated wafer 10 is maintained upon the end effector 12 by a retainer 60 (shown in dashed), such as a plurality of wedge-shaped clamps.

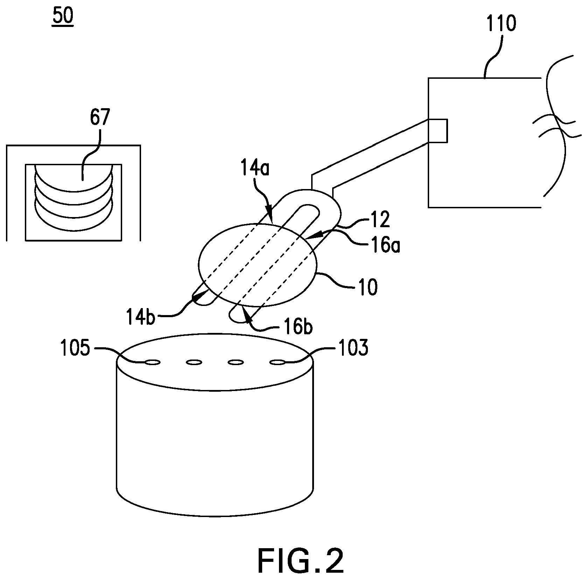

Figure 2 illustrates an automated handling system 50 suitable to precisely handle semiconductor wafers of varying diameters, compositions and physical attributes. The handling system 50 may be capable of handling the substrates, such as wafer 10, in a rapid, ordered succession for processing. The substrates 10 supplied may be manipulated or transferred upon end effector 12 among and between stacks 67 and various stationary points 103 for processing, in part, by robotics, such as may be provided in base 110, to perform the aforementioned manipulation and transfer. The stationary points 103 may comprise one or more chucks, such as may grip the substrates 10 upon placement onto the chuck 103. This gripping may be performed, by way of example, through the use of one or more vacuums 105.

The illustrated wafer 10 may be maintained upon the end effector 12 by, for example, two pairs of opposing wedge clamps 14a, 14b, 16a, 16b. In short, each opposing pair 14a-b, 16a-b comprises a proximal wedge clamp 14a, 16a and a distal wedge clamp 14b, 16b, thus providing wedge clamps at four "corners" of the gripped wafer 10.

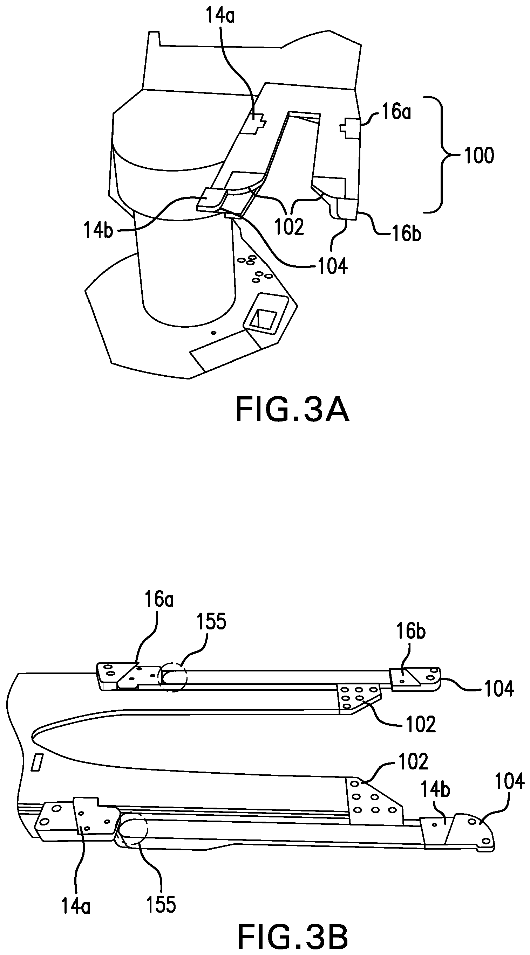

Figure 3A illustrates a front view of an end effector 12 akin to that illustrated in Figure 2. In the illustration of Figure 3A, the end effector 12 comprises a servo driven fork 100 with inner and outer jaws 102, 104 that synchronously move to the center in order to grip a wafer 10 placed within the four "corner" wedge clamps 14a-b, 16a-b shown.

Figure 3B is a profile illustration of the end effector 12 of Figure 3A. As shown, the distal most wedge clamps 14b, 16b (from the end effector base housing 110, not shown in Figure 3B) may be cammed 150 distally outward from the housing 110 by jaws 102, 104, thereby lengthening the distance between a respective pair comprised of a distal wedge clamp 14b, 16b and its corresponding proximal wedge clamp 14a, 16a. More particularly, a decrease in the distance between each respective pair of wedge clamps 14a-b, 16a-b exerts friction on the wafer 10 (not shown in Figure 3B) gripped therebetween, and thus causes the circumferential edges of the wafer 10 between each respective pair of wedge clamps 14a-b, 16a-b to exert loading pressure on, for example, springs associated with each respective distal and proximal wedge clamp pair 14a-b, 16a-b (springs not shown in Figure 3B).

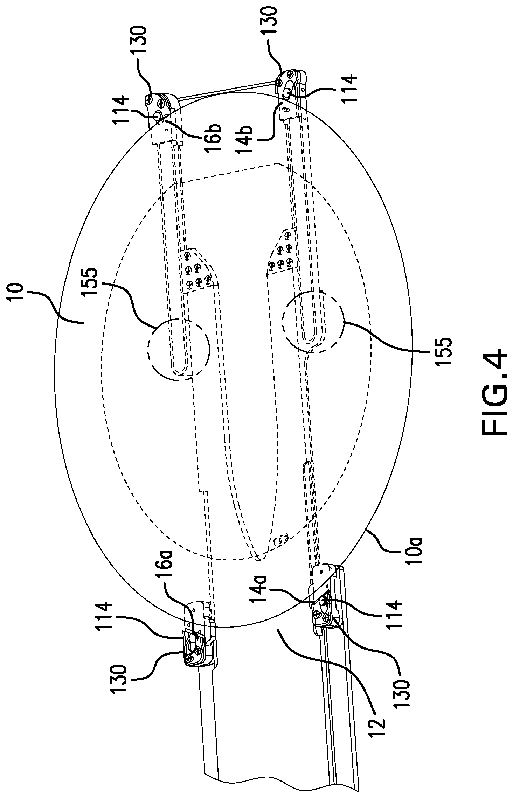

With reference now additionally to Figure 4, the application of loading pressure caused by the decrease in distance between each pair of wedge clamps 14a-b, 16a-b may spring load an extraction cam 114 into the respective wedge housing 130, thereby gripping the wafer's circumferential edge 10a within each respective wedge clamp 14a, b, 16a, b. Of note, this enhanced frictional gripping of the circumferential edge 10a of the wafer 10 thus allows for an increase in available wedge angle, and thereby in an improved wafer grip, over the known art.

More specifically, Figure 4 illustrates a cut-away view of the end effector 12 of Figures 3A and 3B, shown gripping a wafer 10 and applying extraction cams 114 within each of the four corner wedge clamps 14a, b, 16a, b. As shown, each wedge clamp 14a, b, 16a, b may grip the circumferential edge 10a of the gripped wafer 10 when the end effector actuation cams 155 cause a decrease in distance between each distal and proximal pair 14a-b, 16a-b of wedge clamps.

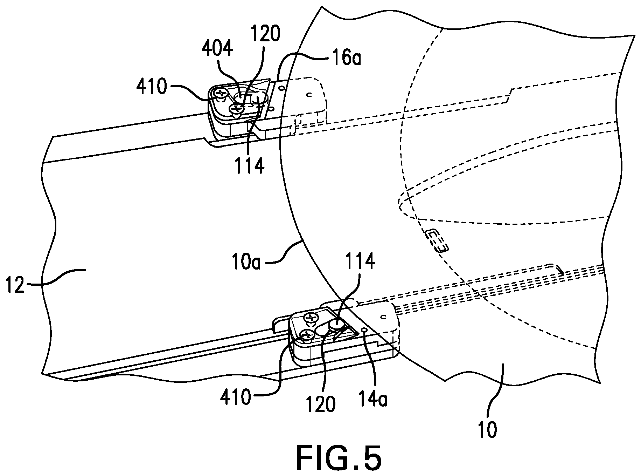

With reference now additionally to Figure 5, this gripping upon contraction causes a compression of the springs 120 associated with each extraction cam 114, and consequently allows for application of each wedge over the circumferential edge 10a of the wafer 10, thus gripping the wafer 10. Accordingly, an increase in the distance between each pair of wedge clamps 14a-b, 16a-b causes a decompression of the spring 120 on each extraction cam 114, thereby causing the extraction cam 114 to spring outwardly from the body of each wedge clamp 14a, b, 16a, b, thus ejecting the edge of the wafer 10 previously gripped.

More particularly, Figure 5 is an illustration of the proximal wedge clamps 16a, b from the illustration of Figure 4. As shown, each of the wedge clamps 14a, 16a may include a sunk cam 114 within a sunk extraction cam guide 404 that allows the extraction cam 114 to be placed in a compressed and decompressed positions. Furthermore, although the spring 120 of each respective extraction cam 114 may be physically associated with any aspect of the wedge clamp housing to provide a base for application of the spring force, the springs 120 are shown in Figure 4 as associated with one or more screws 410 used to screw each wedge clamp onto its respective portion of the edge gripping feature of the end effector 12.

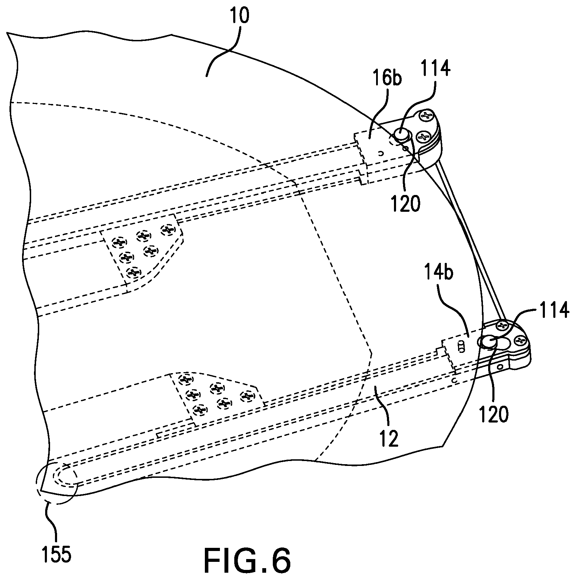

Figure 6, in a manner similar to Figure 5, illustrates a close-up of the distal-most ones 14b, 16b of the pairs of wedge clamps associated with the end effector 12. As illustrated, movement of the cammed portion 155 of the end effector towards the end effector base 110 has compressed the extraction cams 114 into each respective wedge clamp.

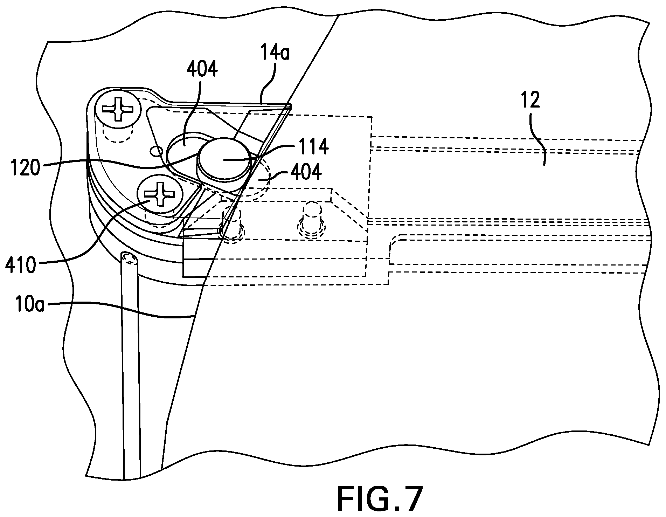

Figure 7 illustrates a top cut away view of a wedge clamp 14a forming a portion of an end effector wafer gripping feature. As shown, the extraction cam spring 120 is loaded about a mounting screw 410 for the wedge clamp 14a, on an innermost portion of the end effector gripping feature.

The extraction cam 114 is then pushed inwardly from the flush position of the wafer clamp's angled portion edge by exertion of pressure from the circumferential portion 10a of the wafer. The extraction cam 114 resides within a sunk guide 404 of the wedge clamp portion and the end effector gripping base portion, wherein the sunk guide 404 is sufficient in length so as to allow the extraction cam 114 to be in the fully compressed and fully decompressed position, based on the spring loading compression pressure applied by the wafer's edge 10a to the extraction cam 114.

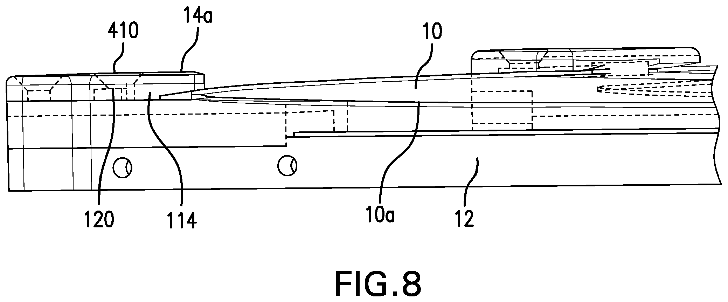

Figure 8 is a profile view of a wafer 10 gripped within the wedge clamp 14a of Figure 7. As shown, the disclosed wedge clamp 14a may have a substantially steeper angle than wedge clamps in the known art, in part because of the affirmative self-releasing pressure applied by the disclosed extraction cam 114 to a gripped wafer's edge 10a.

The foregoing apparatuses, systems and methods may also include the control of the various robotic and vacuum functionality referenced throughout. Such control may include, by way of non-limiting example, manual control using one or more user interfaces, such as a controller, a keyboard, a mouse, a touch screen, or the like, to allow a user to input instructions for execution by software code associated with the robotics and with the systems discussed herein. Additionally, and as is well known to those skilled in the art, system control may also be fully automated, such as wherein manual user interaction only occurs to "set up" and program the referenced functionality, i.e., a user may only initially program or upload computing code to carry out the predetermined movements and operational sequences discussed throughout. In either a manual or automated embodiment, or in any combination thereof, the control may be programmed, for example, to relate the known positions of substrates, the robotics, the stationary points, and the relative positions there between, for example.

It will be appreciated that the herein described systems and methods may operate pursuant to and/or be controlled by any computing environment, and thus the computing environment employed not limit the implementation of the herein described systems and methods to computing environments having differing components and configurations. That is, the concepts described herein may be implemented in any of various computing environments using any of various components and configurations.

Further, the descriptions of the disclosure are provided to enable any person skilled in the art to make or use the disclosed embodiments. Various modifications to the disclosure will be readily apparent to those skilled in the art, and the generic principles defined herein may be applied to other variations without departing from the scope of the invention which is defined by the appended claims.

## Claims

1. A wedge clamp (14a, 14b, 16a, 16b), suitable for fastening to an end effector (12) capable of handling semiconductor wafers (10), comprising:
a housing (130);
a cam (114) movably mounted within the housing (130) and capable of depressing fully into the housing (130) and of decompressing at least partially outside of the housing (130);
a spring (120) loadably pressuring the cam (114), wherein the spring (120) is fully loaded upon the depressing and is unloaded during the decompressing.

2. The wedge clamp of claim 1, wherein the spring (120) is configured to be loaded by a circumferential edge (10a) of the semiconductor wafer (10).

3. The wedge clamp of claim 1, wherein the spring is configured to be loaded by a contraction of the end effector (12).

4. The wedge clamp of claim 1, further comprising a cam travel path into which the cam (114) is movably mounted.

5. An end effector (12) capable of handling a semiconductor wafer (10), comprising:
a robotic base (110);
two inner jaws (102) at least mechanically associated with the robotic base (110);
two outer arms (104) associated with the inner jaws (102) via at least one arms cam system;
a plurality of wedge clamps (14a, 14b, 16a, 16b), wherein two of the plurality of wedge clamps (14a, 14b, 16a, 16b) are respectively fastened to each of the two inner jaws (102) proximally to the robotic base (110), and wherein two of the plurality of wedge clamps (14a, 14b, 16a, 16b) are respectively fastened to each of the outer arms (104) distally from the robotic base (110), and wherein each of at least one of the distal wedge clamps (14b, 16b) and the proximal wedge clamps (14a, 16a) is provided according to one of claims 1 through 4 and further comprises:
a cam travel path into which the cam (114) is slidably associated;
wherein a contraction of the inner jaws (102) and a consequent arms camming of the outer arms (104) applies pressure to a circumferential edge (10a) of the semiconductor wafer (10) such that the circumferential edge (10a) depresses each of the cams (114) along its respective cam travel path and against its respective one of the springs (120), thereby loading the cams (114) to grip the semiconductor wafer (10) within the plurality of wedge clamps (14a, 14b, 16a, 16b).

6. The end effector of claim 5, wherein the robotic base (110) includes a servo motor to drive at least the two inner jaws (102).

7. The end effector of claim 5, wherein the two inner jaws (102) and the two outer arms (104) in conjunction have a fork shape.

8. The end effector of claim 5, wherein all of the wedge clamps (14a, 14b, 16a, 16b) are provided according to one of claims 1 through 4.

9. The end effector of claim 5, wherein the end effector (12 ) is configured to synchronously move the two inner jaws (102).

10. The end effector of claim 5, wherein each of the wedge clamps (14a, 14b, 16a, 16b) is angled.

11. The end effector of claim 5, wherein the wedge clamps (14a, 14b, 16a, 16b) comprise fasteners and each of the springs is loaded about a respective one of its wedge clamp's fasteners.

12. The end effector of claim 11, wherein the fasteners comprise a screw (410).

13. The end effector of claim 5, wherein each of the cam travel paths is sunk within the wedge clamp (14a, 14b, 16a, 16b).

14. The end effector of claim 5, wherein the robotic base (110) is configured to rotate the two outer arms (104) from 180 to 360 degrees.

## Patentansprüche

1. Keilklemme (14a, 14b, 16a, 16b), geeignet zur Befestigung an einem Endeffektor (12), der Halbleiterwafer (10) handhaben kann, umfassend:
ein Gehäuse (130);
einen Nocken (114), der beweglich innerhalb des Gehäuses (130) montiert ist und vollständig in das Gehäuse (130) niedergedrückt und zumindest teilweise außerhalb des Gehäuses (130) dekomprimiert werden kann;
eine Feder (120), die den Nocken (114) belastbar unter Druck drückt, wobei die Feder (120) beim Niederdrücken vollständig belastet und während des Dekomprimierens entlastet wird.

2. Keilklemme nach Anspruch 1, wobei die Feder (120) dazu konfiguriert ist, durch eine Umfangskante (10a) des Halbleiterwafers (10) belastet zu werden.

3. Keilklemme nach Anspruch 1, wobei die Feder dazu konfiguriert ist, durch eine Kontraktion des Endeffektors (12) belastet zu werden.

4. Keilklemme nach Anspruch 1, umfassend ferner einen Nockenlaufweg, in den der Nocken (114) beweglich eingebaut ist.

5. Endeffektor (12), der einen Halbleiterwafer (10) handhaben kann, umfassend:
eine Roboterbasis (110);
zwei Innenbacken (102), die zumindest mechanisch mit der Roboterbasis (110) assoziiert sind;
zwei Außenarme (104), die über mindestens ein Armnockensystem mit den Innenbacken (102) assoziiert sind;
mehrere Keilklemmen (14a, 14b, 16a, 16b), wobei zwei der mehreren Keilklemmen (14a, 14b, 16a, 16b) jeweils an jeder der beiden Innenbacken (102) proximal zur Roboterbasis (110) befestigt sind, und wobei zwei der mehreren Keilklemmen (14a, 14b, 16a, 16b) jeweils an jedem der Außenarme (104) distal von der Roboterbasis (110) befestigt sind, und wobei jede von mindestens einer der distalen Keilklemmen (14b, 16b) und der proximalen Keilklemmen (14a, 16a) gemäß einem der Ansprüche 1 bis 4 vorgesehen ist und weiterhin Folgendes umfasst:
einen Nockenlaufweg, in den der Nocken (114) verschiebbar eingebunden ist;
wobei eine Kontraktion der Innenbacken (102) und ein daraus resultierendes Arm-Camming der Außenarme (104) Druck auf eine Umfangskante (10a) des Halbleiterwafers (10) ausüben, so dass die Umfangskante (10a) jeden der Nocken (114) entlang seines jeweiligen Nockenlaufwegs und gegen seine jeweilige der Federn (120) niederdrückt, wodurch die Nocken (114) belastet werden, um den Halbleiterwafer (10) innerhalb der mehreren Keilklemmen (14a, 14b, 16a, 16b) zu greifen.

6. Endeffektor nach Anspruch 5, wobei die Roboterbasis (110) einen Servomotor zum Antrieb mindestens der beiden Innenbacken (102) umfasst.

7. Endeffektor nach Anspruch 5, wobei die beiden Innenbacken (102) und die beiden Außenarme (104) zusammen eine Gabelform aufweisen.

8. Endeffektor nach Anspruch 5, wobei alle Keilklemmen (14a, 14b, 16a, 16b) gemäß einem der Ansprüche 1 bis 4 vorgesehen sind.

9. Endeffektor nach Anspruch 5, wobei der Endeffektor (12) dazu konfiguriert ist, die beiden Innenbacken (102) synchron zu bewegen.

10. Endeffektor nach Anspruch 5, wobei jede der Keilklemmen (14a, 14b, 16a, 16b) abgewinkelt ist.

11. Endeffektor nach Anspruch 5, wobei die Keilklemmen (14a, 14b, 16a, 16b) Befestigungselemente umfassen und jede der Federn um ein jeweiliges der Befestigungselemente ihrer Keilklemme belastet ist.

12. Endeffektor nach Anspruch 11, wobei die Befestigungselemente eine Schraube (410) umfassen.

13. Endeffektor nach Anspruch 5, wobei jeder der Nockenlaufwege innerhalb der Keilklemme (14a, 14b, 16a, 16b) versenkt ist.

14. Endeffektor nach Anspruch 5, wobei die Roboterbasis (110) dazu konfiguriert ist, die beiden Außenarme (104) von 180 Grad auf 360 Grad zu drehen.

## Revendications

1. Serre-joint à coin (14a, 14b, 16a, 16b), convenable pour s'attacher à un effecteur terminal (12) capable de manipuler des plaquettes semi-conductrices (10), comprenant :
un boîtier (130) ;
une came (114) montée de manière mobile à l'intérieur du boîtier (130) et capable de s'enfoncer complètement à l'intérieur du boîtier (130) et de se décompresser au moins partiellement à l'extérieur du boîtier (130) ;
un ressort (120) exerçant une pression de manière apte à être chargé sur la came (114), dans lequel le ressort (120) est complètement chargé lors de l'enfoncement et est déchargé lors de la décompression.

2. Serre-joint à coin selon la revendication 1, dans lequel le ressort (120) est configuré pour être chargé par un bord circonférentiel (10a) de la plaquette semi-conductrice (10).

3. Serre-joint à coin selon la revendication 1, dans lequel le ressort est configuré pour être chargé par une contraction de l'effecteur terminal (12).

4. Serre-joint à coin selon la revendication 1, comprenant en outre un chemin de déplacement de came dans lequel la came (114) est montée de manière mobile.

5. Effecteur terminal (12) capable de manipuler une plaquette semi-conductrice (10), comprenant :
une base robotique (110) ;
deux mâchoires internes (102) au moins associées mécaniquement à la base robotique (110) ;
deux bras externes (104) associés aux mâchoires internes (102) via au moins un système de came de bras ;
une pluralité de serre-joints à coin (14a, 14b, 16a, 16b), dans laquelle deux parmi la pluralité de serre-joints à coin (14a, 14b, 16a, 16b) sont respectivement attachés à chacune des deux mâchoires internes (102) de manière proximale à la base robotique (110), et dans laquelle deux parmi la pluralité de serre-joints à coin (14a, 14b, 16a, 16b) sont respectivement attachés à chacun des bras externes (104) de manière distale de la base robotique (110), et dans laquelle chacun d'au moins un des serre-joints à coin distaux (14b, 16b) et des serre-joints à coin proximaux (14a, 16a) est prévu selon l'une des revendications 1 à 4 et comprend en outre :
un chemin de déplacement de came à l'intérieur duquel la came (114) est associée de manière glissante ;
dans lequel une contraction des mâchoires internes (102) et une action de came consécutive des bras externes (104) appliquent une pression sur un bord circonférentiel (10a) de la plaquette semi-conductrice (10), de sorte que le bord circonférentiel (10a) enfonce chacune des cames (114) le long de son chemin de déplacement de came respectif et contre un de ses ressorts (120) respectifs, chargeant ainsi les cames (114) afin de serrer la plaquette semi-conductrice (10) au sein de la pluralité de serre-joints à coin (14a, 14b, 16a, 16b).

6. Effecteur terminal selon la revendication 5, dans lequel la base robotique (110) comporte un moteur servo pour entraîner au moins les deux mâchoires internes (102).

7. Effecteur terminal selon la revendication 5, dans lequel les deux mâchoires internes (102) et les deux bras externes (104) ont conjointement une forme de fourche.

8. Effecteur terminal selon la revendication 5, dans lequel tous les serre-joints à coin (14a, 14b, 16a, 16b) sont prévus selon l'une des revendications 1 à 4.

9. Effecteur terminal selon la revendication 5, dans lequel l'effecteur terminal (12) est configuré pour déplacer de manière synchrone les deux mâchoires internes (102).

10. Effecteur terminal selon la revendication 5, dans lequel chacun des serre-joints à coin (14a, 14b, 16a, 16b) est incliné.

11. Effecteur terminal selon la revendication 5, dans lequel les serre-joints à coin (14a, 14b, 16a, 16b) comprennent des fixations et chacun des ressorts est chargé autour d'une de ses fixations respectives de serre-joint à coin.

12. Effecteur terminal selon la revendication 11, dans lequel la fixation comprend une vis (410).

13. Effecteur terminal selon la revendication 5, dans lequel chacun des chemins de déplacement de came est encastré au sein du serre-joint à coin (14a, 14b, 16a, 16b).

14. Effecteur terminal selon la revendication 5, dans lequel la base robotique (110) est configurée pour faire tourner les deux bras externes (104) de 180 à 360 degrés.
